# EUROPEAN PATENT APPLICATION

(11) **EP 4 768 956 A1**
(43) Date of publication of application: **01.07.2026**
(21) Application number: 24925006.9
(22) Date of filing: 12.11.2024
(51) Int. Cl.: G01R 31/392, G01R 31/389, G01R 31/385, G01R 31/396, G01R 1/20, G01R 19/165, G01R 19/10

(54) **BATTERY DIAGNOSIS DEVICE AND METHOD FOR OPERATING SAME**

(30) Priority: 13.02.2024 KR 20240020603
(71) Applicant: LG Energy Solution, Ltd., Seoul 07335 (KR)
(72) Inventor: MOON, Cheoul Woo, Daejeon 34122 (KR)
(74) Representative: Plasseraud IP
(86) International application number: PCT/KR2024/017837
(87) International publication number: WO 2025/173862

(57) **Abstract**

A battery diagnosis apparatus according to an embodiment disclosed herein includes an information obtaining unit configured to obtain a shunt voltage and a shunt current of a current detection resistor (shunt resistor), a storage unit configured to store a voltage of the battery pack, and a control unit configured to store a first voltage, which is a voltage of the battery pack at a first point in time corresponding to a rest state of the battery pack, and a second voltage, which is a voltage of the battery pack at a second point in time after a first interval from the first point in time and diagnose a state of the current detection resistor, based on the difference between the second voltage and the first voltage and the shunt current.

## Description

### Technical Field

### CROSS-REFERENCE TO RELATED APPLICATION

This application claims priority to and the benefit of Korean Patent Application No. 10-2024-0020603 filed in the Korean Intellectual Property Office on February 13, 2024, the entire content of which is incorporated herein by reference.

### TECHNICAL FIELD

Embodiments disclosed herein relate to a battery diagnosis apparatus and an operating method thereof.

### Background Art

Recently, demands for portable electronic products such as laptops, video cameras, portable phones, etc., have increased rapidly, and as the development of electric vehicles, energy storage batteries, robots, satellites, etc., is rapidly advancing, research on high-performance batteries that may be repeatedly charged and discharged has been actively pursued.

Current commercial secondary batteries include nickel cadmium batteries, nickel hydrogen batteries, nickel zinc batteries, lithium batteries, etc. Among these batteries, lithium batteries have been highlighted because they are charged and discharged freely with a little memory effect compared to nickel-based batteries, and also have very low self-discharge rate and high energy density.

Battery packs are used in various fields, and often require large capacities like in electric-driven vehicles or smart grid systems. To increase a capacity of the battery pack, a capacity of the secondary battery, i.e., the battery cell may increase, but in this case, a capacity increase effect is not large, and there is a physical limitation in the size expansion of the secondary battery. Thus, generally, a battery pack is widely used in which a plurality of battery modules are connected in series and in parallel.

To measure the current of the battery pack, a current detection resistor (shunt resistor) may be used. To this end, a resistor of a fine magnitude may be serially connected to the inside of the battery pack, a voltage flowing through the resistor may be measured, and a current may be calculated based on a resistance value and a voltage value. However, when the resistance value of the current detection resistor changes, the measured current of the battery pack also changes, failing to guarantee the accuracy of current measurement of the battery pack.

### Disclosure

### Technical Problem

Embodiments disclosed herein aim to provide a battery diagnosis apparatus and an operating method thereof in which a current of a battery pack may be measured.

Embodiments disclosed herein aim to provide a battery diagnosis apparatus and an operating method thereof in which a defect of a current detection resistor of a battery pack may be diagnosed.

Embodiments disclosed herein aim to provide a battery diagnosis apparatus and an operating method thereof in which an increase defect or a decrease defect of a current detection resistor of a battery pack may be diagnosed.

Technical problems of the embodiments disclosed herein are not limited to the aforementioned technical problems, and other unmentioned technical problems would be clearly understood by those of ordinary skill in the art from the following description.

### Technical Solution

A battery diagnosis apparatus according to an embodiment disclosed herein includes an information obtaining unit configured to obtain a shunt voltage and a shunt current of a current detection resistor (shunt resistor), a storage unit configured to store a voltage of the battery pack, and a control unit configured to store a first voltage, which is a voltage of the battery pack at a first point in time corresponding to a rest state of the battery pack, and a second voltage, which is a voltage of the battery pack at a second point in time after a first interval from the first point in time and diagnose a state of the current detection resistor, based on the difference between the second voltage and the first voltage and the shunt current.

According to an embodiment, the control unit may be further configured to diagnose that a decrease drift occurs in the current detection resistor when the shunt current corresponding to the second point in time is greater than or equal to a preset first charging/discharging rate and the difference between the second voltage and the first voltage is less than a first set value.

According to an embodiment, the control unit may be further configured to store a third voltage, which is a voltage of the battery pack at a third point in time after a second interval from the first point in time and verify a diagnosis result based on a difference between the third voltage and the first voltage.

According to an embodiment, the control unit may be further configured to determine the first set value based on a temperature of the battery pack.

According to an embodiment, the first set value may be proportional to the temperature of the battery pack.

According to an embodiment, the control unit may be further configured to diagnose that an increase drift occurs in the current detection resistor when the shunt current corresponding to the second point in time is less than a preset second charging/discharging rate and the difference between the second voltage and the first voltage is greater than or equal to the second set value.

According to an embodiment, the control unit may be further configured to store a third voltage, which is a voltage of the battery pack at a third point in time after a second interval from the first point in time and verify a diagnosis result based on the difference between the third voltage and the first voltage.

According to an embodiment, the control unit may be further configured to diagnose the state of the current detection resistor when a rest time, which is a retention time of the rest state of the battery pack before the first point in time, is greater than or equal to a preset time.

According to an embodiment, the control unit may be further configured to initialize a state diagnosis of the current detection resistor when the rest time is less than the preset time.

An operating method of a battery diagnosis apparatus, according to an embodiment disclosed herein includes measuring a shunt voltage of a current detection resistor (shunt resistor) included in a battery pack in parallel connection with the current detection resistor and obtaining a shunt current based on the current detection resistor and the shunt voltage, determining whether the current detection resistor is diagnosable, storing a first voltage, which is a voltage of the battery pack at a first point in time corresponding to a rest state of the battery pack, and a second voltage, which is a voltage of the battery pack at a second point in time after a first interval from the first point in time, and diagnosing a state of the current detection resistor, based on the difference between the second voltage and the first voltage and the shunt current.

According to an embodiment, the diagnosing may include diagnosing that a decrease drift occurs in the current detection resistor when the shunt current corresponding to the second point in time is greater than or equal to a preset first charging/discharging rate and the difference between the second voltage and the first voltage is less than a first set value.

According to an embodiment, the diagnosing may include verifying a diagnosis result based on a difference between the first voltage and a third voltage, which is a voltage of the battery pack at a third point in time after a second interval from the first point in time.

According to an embodiment, the first set value may be determined based on the temperature of the battery pack.

According to an embodiment, the diagnosing may include diagnosing that an increase drift occurs in the current detection resistor when the shunt current corresponding to the second point in time is less than a preset second charging/discharging rate and the difference between the second voltage and the first voltage is greater than or equal to a second set value.

According to an embodiment, the determining of whether the current detection resistor is diagnosable may include diagnosing the state of the current detection resistor when a rest time, which is a retention time of the rest state of the battery pack before the first point in time, is greater than or equal to a preset time and initializing diagnosis of the state of the current detection resistor when the rest time is less than the preset time.

Specific details of other embodiments are included in the detailed description and drawings.

### Advantageous Effects

A battery diagnosis apparatus and an operating method thereof according to embodiments disclosed herein may measure a current of a battery pack.

The battery diagnosis apparatus and the operating method thereof according to embodiments disclosed herein may diagnose a defect of a current detection resistor of the battery pack.

The battery diagnosis apparatus and the operating method thereof according to embodiments disclosed herein may diagnose an increase defect or a decrease defect of the current detection resistor of the battery pack.

The battery diagnosis apparatus and the operating method thereof according to embodiments disclosed herein may improve the accuracy of defect diagnosis of the current detection resistor of the battery pack.

The technical effects of the battery diagnosis apparatus and the operating method thereof according to embodiments disclosed in the present document are not limited to the effects mentioned above, and other effects not mentioned will be clearly understood by those of ordinary skill in the art according to the disclosure of the present document.

### Description of Drawings

FIG. 1 is a block diagram of a battery pack according to an embodiment disclosed herein.
FIG. 2 is a block diagram of a battery diagnosis apparatus according to an embodiment disclosed herein.
FIG. 3 is a schematic diagram showing a method, performed by a battery diagnosis apparatus according to an embodiment disclosed herein, of diagnosing a current measurement resistor.
FIG. 4 is a schematic diagram showing a method, performed by a battery diagnosis apparatus according to an embodiment disclosed herein, of diagnosing a current measurement resistor.
FIG. 5 is a schematic diagram showing a method, performed by a battery diagnosis apparatus according to an embodiment disclosed herein, of diagnosing a current measurement resistor.
FIG. 6 is a schematic diagram showing a method, performed by a battery diagnosis apparatus according to an embodiment disclosed herein, of diagnosing a current measurement resistor.
FIG. 7 is a schematic diagram showing a method, performed by a battery diagnosis apparatus according to an embodiment disclosed herein, of diagnosing a current measurement resistor.
FIG. 8 is a flowchart of an operating method of a battery diagnosis apparatus according to an embodiment disclosed herein.
FIG. 9 is a flowchart showing in detail an operation of diagnosing a state of the current detection resistor of FIG. 8.
FIG. 10 is a block diagram showing a computing system that performs an operating method of a battery diagnosis apparatus according to an embodiment disclosed herein.

With regard to the description of the drawings, identical reference numerals may be used to refer to identical or related elements.

### Mode for Invention

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1st", "2nd," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. In the case of online distribution, at least a part of a computer program product may be at least temporarily stored in a machine-readable storage medium such as a memory of a server of a manufacturer, a server of an application store, or a relay server, or may be generated temporarily. In the case of online distribution, at least a part of a computer program product may be at least temporarily stored in a machine-readable storage medium such as a memory of a server of a manufacturer, a server of an application store, or a relay server, or may be generated temporarily.

According to embodiments disclosed herein, each of the above-described components (e.g., a module or program) may include a single entity or a plurality of entities, some of which may be separately disposed on other components. According to embodiments disclosed herein, one or more of the above-described components or operations may be omitted, or one or more other components or operations may be added. Alternatively or additionally, a plurality of components (e.g., modules or programs) may be integrated into one component. In this case, the integrated component may perform one or more functions of each of the plurality of components in a manner that is the same as or similar to a corresponding component of the plurality of components before the integration. According to embodiments disclosed herein, operations performed by a module, a program, or other components may be executed sequentially, in parallel, repeatedly, or heuristically, or one or more of the operations may be executed in a different order or omitted, or one or more other operations may be added.

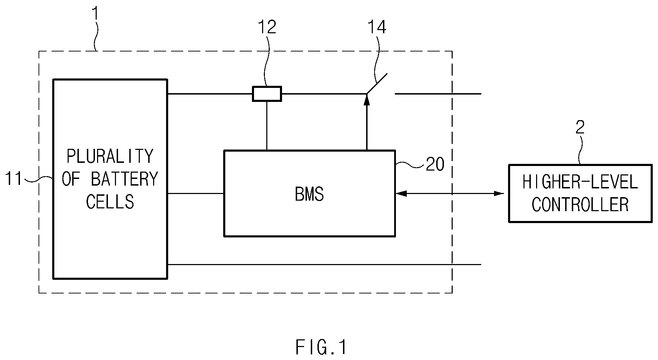

FIG. 1 is a block diagram of a battery pack according to an embodiment disclosed herein.

Referring to FIG. 1, a battery control system including a battery pack 1 and a higher-level controller 2 included in a higher-level system, according to an embodiment of the present disclosure is schematically shown.

As shown in FIG. 1, the battery pack 1 may include one or more battery cells 11, a switching unit 14 serially connected to a first terminal side and/or a second terminal side of the battery cell 11 to control a charging/discharging current flow of the battery cell 11, and a battery management system 20 that performs management to prevent overcharging, over-discharging, etc., by monitoring voltage, current, temperature, etc., of the battery pack 1.

In this case, the battery pack 1 may include the battery cell 11, a sensor 12, the switching unit 14, and the battery management system 20 provided in plural. For example, the first terminal may be a positive (+) terminal of the battery cell 11, and the second terminal may be a negative (-) terminal.

Herein, as the switching unit 14 which is an element for controlling a current flow for charging or discharging of the plurality of battery cells 11, for example, at least one relay, magnetic contactor, etc., may be used according to specifications of the battery pack 1.

The battery management system 20, which is an interface for receiving measurement values of the above-described various parameter values, may include a plurality of terminals and a circuit, etc., connected thereto to process input values. The battery management system 20 may also control on/off of the switching unit 14, e.g., a relay, a contactor, etc., and may be connected to the battery cell 11 to monitor the state of each battery cell 11.

The higher-level controller 2 may transmit a control signal regarding the battery cell 11 to the battery management system 20. Thus, the battery management system 20 may also be controlled in terms of an operation thereof based on a signal applied from the higher-level controller 2.

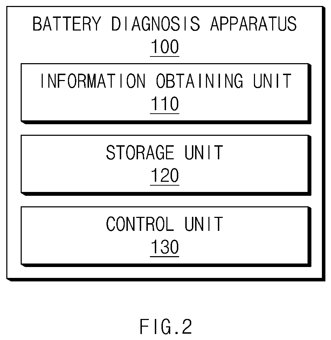

According to an embodiment, the battery management system 20 may include a battery diagnosis apparatus 100 of FIG. 2. According to another embodiment, the battery management system 20 may be different from the battery diagnosis apparatus 100 of FIG. 2. That is, the battery diagnosis apparatus 100 of FIG. 2 may be included in the battery pack 1 and may be configured as another device outside the battery pack 1. Hereinbelow, for convenience of description, it is assumed that the battery diagnosis apparatus 100 includes another device outside the battery pack 1, without being limited thereto. For example, the following operation of the battery diagnosis apparatus 100 may also be performed in various devices such as not only a battery management system (BMS) in a vehicle, but also a server, a cloud, a charger, a charger/discharger, etc.

FIG. 2 is a block diagram of a battery diagnosis apparatus according to an embodiment disclosed herein.

Referring to FIG. 2, the battery diagnosis apparatus 100 may include an information obtaining unit 110, a storage unit 120, and a control unit 130. The battery diagnosis apparatus 100 may diagnose a state of a current detection resistor by using the information obtaining unit 110, the storage unit 120, and the control unit 130.

The information obtaining unit 110 may obtain information related to the battery pack 1. According to an embodiment, the information obtaining unit 110 may obtain information related to the battery pack 1 and a current detection resistor (shunt resistor) included in the battery pack 1. The information obtaining unit 110 may obtain a voltage of the battery pack 1 and a shunt voltage that is a voltage applied to the current detection resistor. For example, the information obtaining unit 110 may directly measure a voltage difference between opposite ends of the current detection resistor to obtain the shunt voltage, but the present disclosure is not limited thereto.

According to an embodiment, the information obtaining unit 110 may obtain a shunt current that is a current flowing into or out of the current detection resistor. For example, the information obtaining unit 110 may obtain the shunt current by, but not limited to, calculating the shunt current based on the resistance of the stored shunt voltage and the obtained shunt voltage.

According to an embodiment, the information obtaining unit 110 may continuously measure the shunt voltage and the shunt current. For example, the information obtaining unit 110 may measure the shunt voltage and the shunt current according to a preset period and transmit the shunt voltage and the shunt current, measured according to the preset period, to the control unit 130.

The storage unit 120 may store information related to the battery pack 1. According to an embodiment, the storage unit 120 may store a voltage of the battery pack 1. For example, the storage unit 120 may store the shunt voltage of the current detection resistor included in the battery pack 1. That is, the storage unit 120 may store the shunt voltage at a plurality of points in time based on control of the control unit 130.

The control unit 130 may determine a rest state of the battery pack 1. According to an embodiment, the control unit 130 may determine the rest state of the battery pack 1 based on the shunt current. For example, the control unit 130 may compare the shunt current with a set value for determining the rest state to determine the rest state of the battery pack 1. That is, the control unit 130 may determine the state of the battery pack 1 as the rest state when the magnitude of the shunt current is less than the set value. The control unit 130 may determine the state of the battery pack 1 as an active state when the magnitude of the shunt current is greater than the set value. Herein, the set value may be, but not limited to, 0.1[A].

According to an embodiment, the control unit 130 may measure a time for maintaining the rest state of the battery pack 1. For example, the control unit 130 may measure the time for maintaining the rest state by using a first timer. Specifically, the control unit 130 may run the first timer when the control unit 130 determines the state of the battery pack 1 as the rest state. The first timer may measure a time based on control of the control unit 130. Specifically, the control unit 130 may stop the first timer when the control unit 130 determines the state of the battery pack 1 as the active state. Thus, the first timer may be stopped. The control unit 130 may measure a time for maintaining the rest state of the battery pack 1 based on a time from a point in time for running the first timer to a point in time for stopping the first timer.

According to an embodiment, the control unit 130 may determine whether to diagnose the state of the current detection resistor. The control unit 130 may determine whether to diagnose the state of the current detection resistor based on the retention time of the rest state. For example, the control unit 130 may diagnose the state of the current detection resistor when the retention time of the rest state is longer than a set time. The control unit 130 may not diagnose the state of the current detection resistor when the retention time of the rest state is shorter than the set time.

The control unit 130 may run when the control unit 130 determines to diagnose the state of the current detection resistor. That is, the control unit 130 may use the second timer to measure a flow of time during diagnosis of the state of the current detection resistor.

The control unit 130 may store a voltage of the battery pack 1. According to an embodiment, the control unit 130 may store a first voltage that is a voltage of the battery pack 1 at a first point in time corresponding to the rest state of the battery pack 1. That is, the first voltage may be a rest state voltage of the battery pack 1.

The control unit 130 may determine an active state of the battery pack 1. According to an embodiment, the control unit 130 may determine the active state of the battery pack 1 based on the shunt current. For example, the control unit 130 may compare the shunt current with a set value for determining the active state to determine the active state of the battery pack 1. That is, the control unit 130 may determine the state of the battery pack 1 as the active state when the magnitude of the shunt current is greater than the set value. The control unit 130 may also determine the state of the battery pack 1 as the rest state when the magnitude of the shunt current is less than the set value. Herein, the set value may be, but not limited to, 0.1[A].

The control unit 130 may reset the second timer when the control unit 130 determines the state of the battery pack 1 as the rest state. The control unit 130 may continue diagnosing the current detection resistor when the control unit 130 determines the state of the battery pack 1 as the active state.

While it is described that the control unit 130 uses the first timer and the second timer, the present disclosure is not limited thereto. For example, the control unit 130 may diagnose the current detection resistor based on one timer.

According to an embodiment, the control unit 130 may determine a diagnosis type. That is, the control unit 130 may determine whether to diagnose an increase drift or a decrease drift of the current detection resistor. The control unit 130 may determine the diagnosis state as one of diagnosis of the increase drift, diagnosis of the decrease drift, and diagnosis non-diagnosability, based on the shunt current.

For example, the control unit 130 may determine the diagnosis state as diagnosis of the decrease drift when the magnitude of the shunt current is greater than or equal to a preset first charging/discharging rate. That is, the control unit 130 may calculate the charging/discharging rate of the shunt current based on the magnitude of the shunt current and a capacity of the battery pack 1, and determine the diagnosis state as diagnosis of the decrease drift when the calculated charging/discharging rate is greater than or equal to a first charging/discharging rate. For example, the control unit 130 may compare the magnitude of the shunt current with a set first reference value based on the capacity of the battery pack 1 to determine the diagnosis state. Herein, the first reference value may correspond to the first charging/discharging rate.

The control unit 130 may determine the diagnosis state as diagnosis of the increase drift when the magnitude of the shunt current is less than a preset second charging/discharging rate. That is, the control unit 130 may calculate the charging/discharging rate of the shunt current based on the magnitude of the shunt current and a capacity of the battery pack 1, and determine the diagnosis state as diagnosis of the increase drift when the calculated charging/discharging rate is less than a second charging/discharging rate. For example, the control unit 130 may compare the magnitude of the shunt current with a set second reference value based on the capacity of the battery pack 1 to determine the diagnosis state. Herein, the second reference value may correspond to the second charging/discharging rate.

Herein, the first charging/discharging rate may be greater than the second charging/discharging rate. For example, the first charging/discharging rate may be 1[C], and the second charging/discharging rate may be 0.5[C]. Thus, a range between the first charging/discharging rate and the second charging/discharging rate may be determined. The control unit 130 may determine the diagnosis state as non-diagnosability when the magnitude of the shunt current falls in the range. In this case, the control unit 130 may initialize the state diagnosis of the current detection resistor.

The control unit 130 may additionally store the voltage of the battery pack 1 when the control unit 130 diagnoses the increase drift of the current detection resistor. That is, the control unit 130 may store a second voltage that is a voltage of the battery pack 1 at a second point in time after a first interval from the first point in time. Herein, the first interval may be, but not limited to, 1[s].

The control unit 130 may diagnose the decrease drift of the current detection resistor based on the first voltage and the second voltage. According to an embodiment, the control unit 130 may compare a difference between the second voltage and the first voltage with a first set value to diagnose the increase drift of the current detection resistor. For example, the control unit 130 may diagnose that the decrease drift occurs in the current detection resistor when the difference between the first voltage and the second voltage is less than the first set value. The control unit 130 may diagnose the state of the current detection resistor as a normal state when the difference between the first voltage and the second voltage is greater than or equal to the first set value.

The control unit 130 may verify a diagnosis result. According to an embodiment, the control unit 130 may store a third voltage that is a voltage of the battery pack 1 at a third point in time after a second interval from the first point in time. Herein, the second interval may be greater than the first interval. That is, the third voltage may be a voltage obtained temporally after the first voltage and the second voltage. The control unit 130 may verify the diagnosis result based on a difference between the third voltage and the first voltage. For example, the control unit 130 may verify the diagnosis result as the normal state when the difference between the first voltage and the third voltage is less than the first set value. The control unit 130 may verify the diagnosis result as an abnormal state when the difference between the first voltage and the third voltage is greater than or equal to the first set value.

According to an embodiment, the control unit 130 may open the current detection resistor when the control unit 130 determines that the decrease drift occurs in the current detection resistor. For example, the control unit 130 may open the current detection resistor by, but not limited to, opening a switch serially connected to the current detection resistor.

The control unit 130 may determine the first set value. According to an embodiment, the control unit 130 may determine the first set value based on a temperature of the battery pack 1. As the current of the battery pack 1 increases with the temperature increase of the battery pack 1 and decreases with the temperature decrease of the battery pack 1, the shunt current for diagnosis of the current detection resistor may also increase with the temperature increase of the battery pack 1 and decrease with the temperature decrease of the battery pack 1. Thus, the control unit 130 may determine the first set value that is to be compared with the shunt current, based on the temperature of the battery pack 1. For example, the control unit 130 may increase the first set value when the temperature of the battery pack 1 increases. The control unit 130 may decrease the first set value when the temperature of the battery pack 1 decreases. That is, the first set value may be proportional to the temperature of the battery pack 1.

Meanwhile, the control unit 130 may additionally store the voltage of the battery pack 1 when the control unit 130 diagnoses the decrease drift of the current detection resistor. That is, the control unit 130 may store a second voltage that is a voltage of the battery pack 1 at a second point in time after a first interval from the first point in time. Herein, the first interval may be, but not limited to, 1[s].

The control unit 130 may diagnose the increase drift of the current detection resistor based on the first voltage and the second voltage. According to an embodiment, the control unit 130 may compare the difference between the second voltage and the first voltage with a second set value to diagnose the increase drift of the current detection resistor. For example, the control unit 130 may diagnose that the increase drift occurs in the current detection resistor when the difference between the first voltage and the second voltage is greater than or equal to the second set value. The control unit 130 may diagnose the state of the current detection resistor as the normal state when the difference between the first voltage and the second voltage is less than the second set value.

The control unit 130 may verify a diagnosis result. According to an embodiment, the control unit 130 may store a third voltage that is a voltage of the battery pack 1 at a third point in time after a second interval from the first point in time. Herein, the second interval may be greater than the first interval. That is, the third voltage may be a voltage obtained temporally after the first voltage and the second voltage. The control unit 130 may verify the diagnosis result based on a difference between the third voltage and the first voltage. For example, the control unit 130 may verify the diagnosis result as the normal state when the difference between the first voltage and the third voltage is greater than equal to the second set value. The control unit 130 may verify the diagnosis result as the abnormal state when the difference between the first voltage and the third voltage is less than the second set value.

According to an embodiment, the control unit 130 may open the current detection resistor when the control unit 130 determines that the increase drift occurs in the current detection resistor. For example, the control unit 130 may open the current detection resistor by, but not limited to, opening a switch serially connected to the current detection resistor.

The control unit 130 may determine the second set value. According to an embodiment, the control unit 130 may determine the second set value based on the temperature of the battery pack 1. As the current of the battery pack 1 increases with the temperature increase of the battery pack 1 and decreases with the temperature decrease of the battery pack 1, the shunt current for diagnosis of the current detection resistor may also increase with the temperature increase of the battery pack 1 and decrease with the temperature decrease of the battery pack 1. Thus, the control unit 130 may determine the second set value that is to be compared with the shunt current, based on the temperature of the battery pack 1. For example, the control unit 130 may increase the second set value when the temperature of the battery pack 1 increases. The control unit 130 may decrease the second set value when the temperature of the battery pack 1 decreases. That is, the second set value may be proportional to the temperature of the battery pack 1.

According to an embodiment, the control unit 130 may provide the diagnosis result to a user when the control unit 130 diagnoses the state of the current detection resistor as the increase drift or the decrease drift. For example, the controller 130 may provide the diagnosis result to a user terminal through a communication unit (not shown) and also provide the diagnosis result to the user through a display provided in a vehicle, a charger, etc.

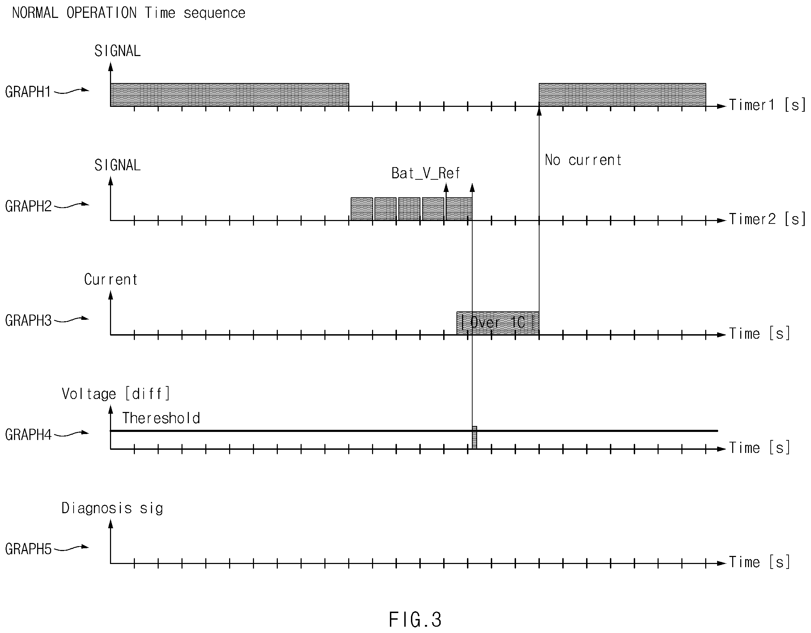

Hereinbelow, with reference to FIGS. 3 to 7, a method, performed by the battery diagnosis apparatus 100, of diagnosing the current detection resistor according to an individual situation of the battery pack 1 will be described. In FIGS. 3 to 7, a first graph GRAPH1 shows an operation of the first timer over time. A second graph GRAPH2 shows an operation of the second timer over time. A third graph GRAPH3 shows a magnitude of a shunt current over time. A fourth graph GRAPH4 shows a difference between the first voltage and the second voltage over time. A fifth graph GRAPHS shows a diagnosis signal over time.

The battery diagnosis apparatus 100 may measure the current of the battery pack 1 based on the resistance value and the shunt voltage of the current detection resistor. The battery diagnosis apparatus 100 may also diagnose a defect of the current detection resistor of the battery pack 1 based on the shunt voltage and the shunt current.

The battery diagnosis apparatus 100 may compare the voltage of the active state of the battery pack 1 with the voltage of the rest state to diagnose the increase defect or the decrease defect of the current detection resistor of the battery pack 1.

The battery diagnosis apparatus 100 may improve the accuracy of diagnosis of the current detection resistor of the battery pack 1 by diagnosing the current detection resistor when the shunt current is maintained for a set time or longer. That is, the battery diagnosis apparatus 100 may improve the accuracy of diagnosis of the current detection resistor by preventing a situation where the current detection resistor is diagnosed based on a temporarily increasing or decreasing current.

FIG. 3 is a schematic diagram showing a method, performed by a battery diagnosis apparatus according to an embodiment disclosed herein, of diagnosing a current measurement resistor.

Referring to FIG. 3, the control unit 130 may diagnose the state of the current detection resistor. The control unit 130 may determine a rest state of the battery pack 1. Referring to the third graph GRAPH3, the control unit 130 may determine the state of the battery pack 1 as the rest state when the shunt current is less than the set value. Referring to the first graph GRAPH1, the control unit 130 may run the first timer when the control unit 130 determines the state of the battery pack 1 as the rest state. The control unit 130 may measure a duration of the rest state of the battery pack 1 by using the first timer. When the duration of the rest state of the control unit 130 is greater than or equal to a set time, the control unit 130 may stop the first timer and run the second timer. Herein, the set time may be, but not limited to, 10[s].

Referring to the second graph GRAPH2, the control unit 130 may run the second timer while stopping the first timer. The control unit 130 may use the second timer to measure a flow of time during diagnosis of the state of the current detection resistor. According to an embodiment, the control unit 130 may run the second timer for a set time to identify the shunt current and stop and reset the second timer. Herein, the set time may be, but not limited to, 1[s].

Referring to the third graph GRAPH3, the control unit 130 may identify the shunt current at a stop point in time of the second timer. The control unit 130 may diagnose the state of the current detection resistor based on the shunt voltage when the shunt current is greater than or equal to the first charging/discharging rate. Herein, the first charging/discharging rate may be, but not limited to, 1[C].

Referring to the fourth graph GRAPH4, the control unit 130 may diagnose the state of the current detection resistor based on the shunt voltage. According to an embodiment, the control unit 130 may compare the difference between the first voltage, which is a voltage of the battery pack 1 at the first point in time corresponding to the rest state of the battery pack 1, and the second voltage, which is a voltage of the battery pack 1 at the second point in time after the first interval from the first point in time, with the first set value. When the difference between the first voltage and the second voltage is greater than or equal to the first set value, the control unit 130 may determine the state of the current detection resistor as the normal state and initialize diagnosis of the current detection resistor.

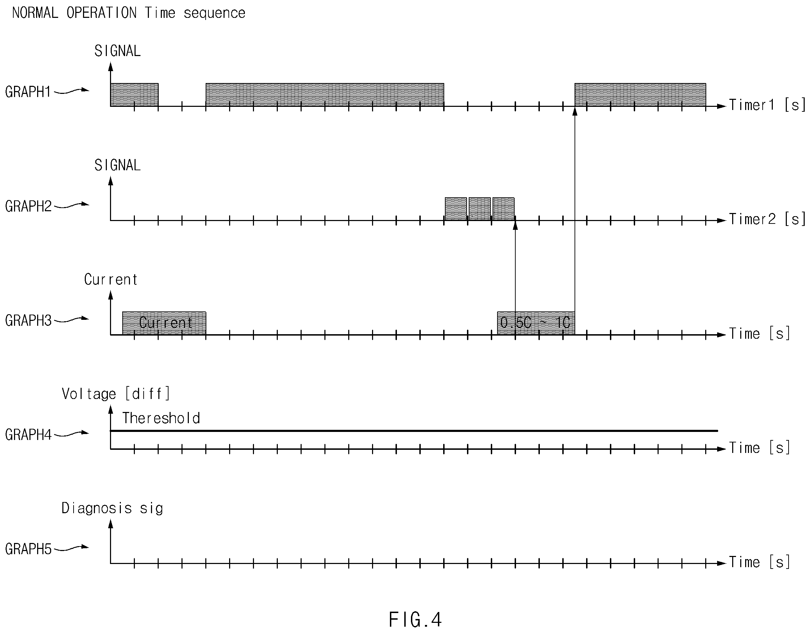

FIG. 4 is a schematic diagram showing a method, performed by a battery diagnosis apparatus according to an embodiment disclosed herein, of diagnosing a current measurement resistor.

Referring to FIG. 4, the control unit 130 may diagnose the state of the current detection resistor. The control unit 130 may determine a rest state of the battery pack 1. Referring to the third graph GRAPH3, the control unit 130 may determine the state of the battery pack 1 as the rest state when the shunt current is less than the set value. Referring to the first graph GRAPH1, the control unit 130 may run the first timer when the control unit 130 determines the state of the battery pack 1 as the rest state. The control unit 130 may measure a duration of the rest state of the battery pack 1 by using the first timer. When the duration of the rest state of the control unit 130 is greater than or equal to a set time, the control unit 130 may stop the first timer and run the second timer. Herein, the set time may be, but not limited to, 10[s].

Referring to the second graph GRAPH2, the control unit 130 may run the second timer while stopping the first timer. The control unit 130 may use the second timer to measure a flow of time during diagnosis of the state of the current detection resistor. According to an embodiment, the control unit 130 may run the second timer for a set time to identify the shunt current and stop and reset the second timer. Herein, the set time may be, but not limited to, 1[s].

Referring to the third graph GRAPH3, the control unit 130 may identify the shunt current at a stop point in time of the second timer. The control unit 130 may determine that the diagnosis state of the current detection resistor as non-diagnosability when the shunt current is at least the second charging/discharging rate, but not more than the first charging/discharging rate. In this case, the control unit 130 may initialize the state diagnosis of the current detection resistor. Herein, the first charging/discharging rate may be 1[C] and the second charging/discharging rate may be 0.5[C], but the present disclosure is not limited thereto.

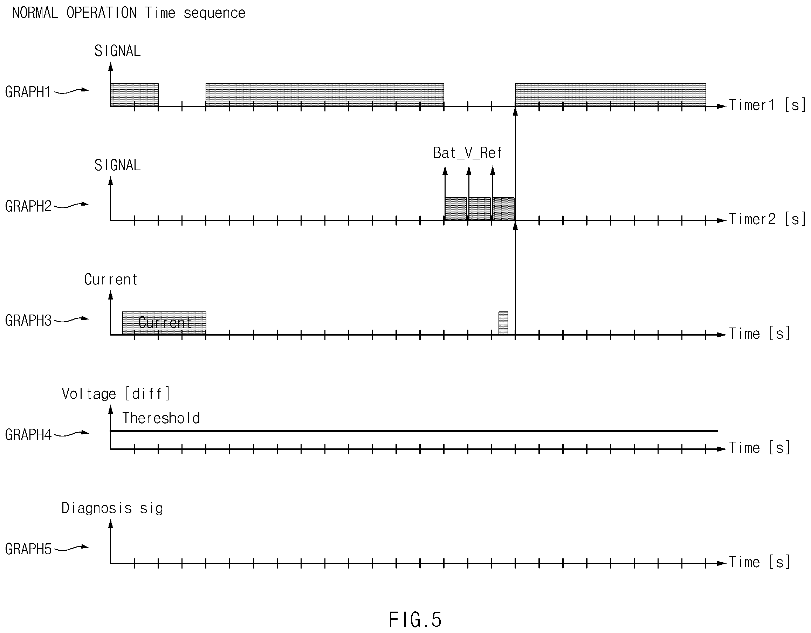

FIG. 5 is a schematic diagram showing a method, performed by a battery diagnosis apparatus according to an embodiment disclosed herein, of diagnosing a current measurement resistor.

Referring to FIG. 5, the control unit 130 may diagnose the state of the current detection resistor. The control unit 130 may determine a rest state of the battery pack 1. Referring to the third graph GRAPH3, the control unit 130 may determine the state of the battery pack 1 as the rest state when the shunt current is less than the set value. Referring to the first graph GRAPH1, the control unit 130 may run the first timer when the control unit 130 determines the state of the battery pack 1 as the rest state. The control unit 130 may measure a duration of the rest state of the battery pack 1 by using the first timer. When the duration of the rest state of the control unit 130 is greater than or equal to a set time, the control unit 130 may stop the first timer and run the second timer. Herein, the set time may be, but not limited to, 10[s].

Referring to the second graph GRAPH2, the control unit 130 may run the second timer while stopping the first timer. The control unit 130 may use the second timer to measure a flow of time during diagnosis of the state of the current detection resistor. In this case, the control unit 130 may store the first voltage that is a voltage of the battery pack 1 at a running point in time of the second timer. According to an embodiment, the control unit 130 may run the second timer for a set time to identify the shunt current and stop and reset the second timer. Herein, the set time may be, but not limited to, 1[s].

Referring to the third graph GRAPH3, the control unit 130 may identify the shunt current at a stop point in time of the second timer. The control unit 130 may initialize diagnosis of the current detection resistor when the shunt current does not flow at a stop point in time of the second timer. That is, the control unit 130 may diagnose the current detection resistor based on the shunt current when the shunt current is maintained for a set time. To this end, the control unit 130 may improve the accuracy of diagnosis of the current detection resistor by preventing the current detection resistor from being misdiagnosed due to the temporary increase/decrease of current.

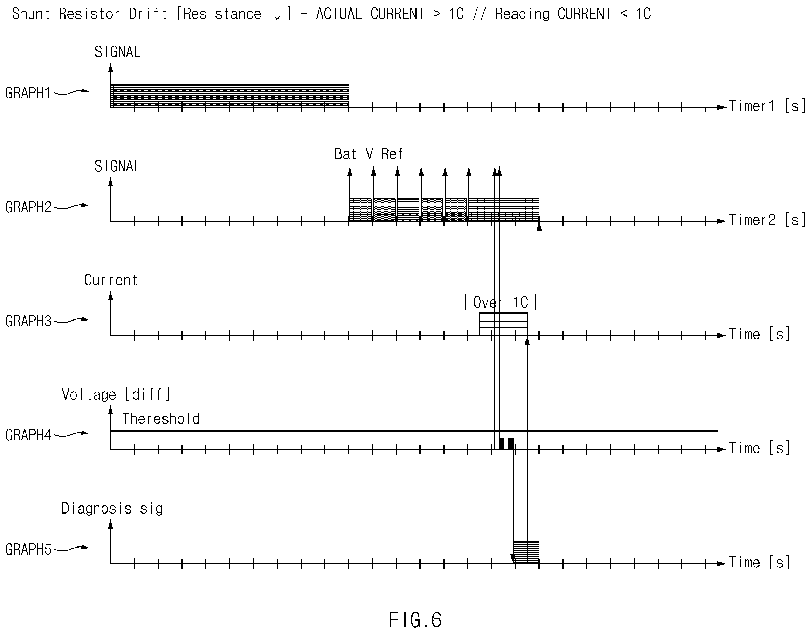

FIG. 6 is a schematic diagram showing a method, performed by a battery diagnosis apparatus according to an embodiment disclosed herein, of diagnosing a current measurement resistor.

Referring to FIG. 6, the control unit 130 may diagnose the state of the current detection resistor. The control unit 130 may determine a rest state of the battery pack 1. Referring to the third graph GRAPH3, the control unit 130 may determine the state of the battery pack 1 as the rest state when the shunt current is less than the set value. Referring to the first graph GRAPH1, the control unit 130 may run the first timer when the control unit 130 determines the state of the battery pack 1 as the rest state. The control unit 130 may measure a duration of the rest state of the battery pack 1 by using the first timer. When the duration of the rest state of the control unit 130 is greater than or equal to a set time, the control unit 130 may stop the first timer and run the second timer. Herein, the set time may be, but not limited to, 10[s].

Referring to the second graph GRAPH2, the control unit 130 may run the second timer while stopping the first timer. The control unit 130 may use the second timer to measure a flow of time during diagnosis of the state of the current detection resistor. According to an embodiment, the control unit 130 may run the second timer for a set time to identify the shunt current and stop and reset the second timer. Herein, the set time may be, but not limited to, 1[s].

Referring to the third graph GRAPH3, the control unit 130 may identify the shunt current at a stop point in time of the second timer. The control unit 130 may diagnose the state of the current detection resistor based on the shunt voltage when the shunt current is greater than or equal to the first charging/discharging rate. Herein, the first charging/discharging rate may be, but not limited to, 1[C].

Referring to the fourth graph GRAPH4, the control unit 130 may diagnose the state of the current detection resistor based on the shunt voltage. According to an embodiment, the control unit 130 may compare the difference between the first voltage, which is a voltage of the battery pack 1 at the first point in time corresponding to the rest state of the battery pack 1, and the second voltage, which is a voltage of the battery pack 1 at the second point in time after the first interval from the first point in time, with the first set value. When the difference between the first voltage and the second voltage is less than the first set value, the control unit 130 may diagnose the state of the current detection resistor as the decrease drift. In this case, the control unit 130 may verify a diagnosis result. For example, the control unit 130 may store the third voltage that is a voltage of the battery pack 1 at a third point in time after the second interval from the first point in time and compare the difference between the first voltage and the third voltage with the first set value. When the difference between the first voltage and the third voltage is less than the first set value, the control unit 130 may verify the diagnosis result as the normal state.

Referring to the fifth graph GRAPHS, the control unit 130 may input a diagnosis signal. According to an embodiment, the control unit 130 may input the diagnosis signal when the control unit 130 diagnoses the state of the current detection resistor as the decrease drift. When the diagnosis signal is identified, the control unit 130 may open the current detection resistor. For example, the control unit 130 may open the current detection resistor by, but not limited to, opening a switch serially connected to the current detection resistor.

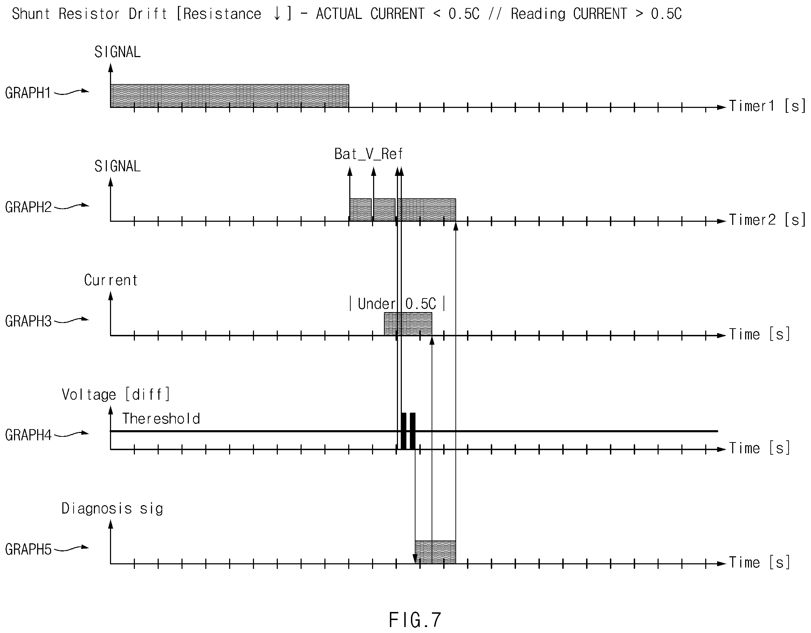

FIG. 7 is a schematic diagram showing a method, performed by a battery diagnosis apparatus according to an embodiment disclosed herein, of diagnosing a current measurement resistor.

Referring to FIG. 7, the control unit 130 may diagnose the state of the current detection resistor. The control unit 130 may determine a rest state of the battery pack 1. Referring to the third graph GRAPH3, the control unit 130 may determine the state of the battery pack 1 as the rest state when the shunt current is less than the set value. Referring to the first graph GRAPH1, the control unit 130 may run the first timer when the control unit 130 determines the state of the battery pack 1 as the rest state. The control unit 130 may measure a duration of the rest state of the battery pack 1 by using the first timer. When the duration of the rest state of the control unit 130 is greater than or equal to a set time, the control unit 130 may stop the first timer and run the second timer. Herein, the set time may be, but not limited to, 10[s].

Referring to the second graph GRAPH2, the control unit 130 may run the second timer while stopping the first timer. The control unit 130 may use the second timer to measure a flow of time during diagnosis of the state of the current detection resistor. According to an embodiment, the control unit 130 may run the second timer for a set time to identify the shunt current and stop and reset the second timer. Herein, the set time may be, but not limited to, 1[s].

Referring to the third graph GRAPH3, the control unit 130 may identify the shunt current at a stop point in time of the second timer. The control unit 130 may diagnose the state of the current detection resistor based on the shunt voltage when the shunt current is less than the second charging/discharging rate. Herein, the second charging/discharging rate may be, but not limited to, 0.5[C].

Referring to the fourth graph GRAPH4, the control unit 130 may diagnose the state of the current detection resistor based on the shunt voltage. According to an embodiment, the control unit 130 may compare the difference between the first voltage, which is a voltage of the battery pack 1 at the first point in time corresponding to the rest state of the battery pack 1, and the second voltage, which is a voltage of the battery pack 1 at the second point in time after the first interval from the first point in time, with the second set value. When the difference between the first voltage and the second voltage is less than the second set value, the control unit 130 may diagnose the state of the current detection resistor as the increase drift. In this case, the control unit 130 may verify a diagnosis result. For example, the control unit 130 may store the third voltage after the second interval from the first point in time and compare the difference between the first voltage and the third voltage with the second set value. When the difference between the first voltage and the third voltage is less than the second set value, the control unit 130 may verify the diagnosis result as the normal state.

Referring to the fifth graph GRAPHS, the control unit 130 may input a diagnosis signal. According to an embodiment, the control unit 130 may input the diagnosis signal when the control unit 130 diagnoses the state of the current detection resistor as the increase drift. When the diagnosis signal is identified, the control unit 130 may open the current detection resistor. For example, the control unit 130 may open the current detection resistor by, but not limited to, opening a switch serially connected to the current detection resistor.

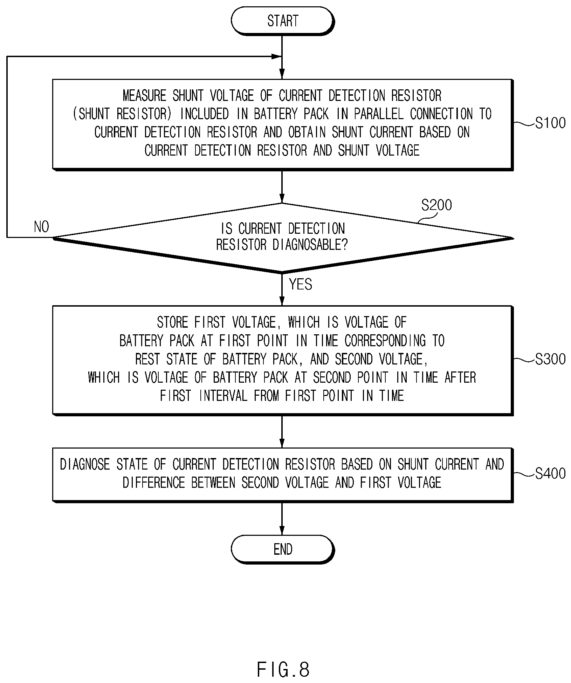

FIG. 8 is a flowchart of an operating method of a battery diagnosis apparatus according to an embodiment disclosed herein.

An embodiment shown in FIG. 8 is merely an embodiment, and an order of operations according to various embodiments of the present disclosure may be different from that shown in FIG. 8, some operations shown in FIG. 8 may be omitted, or an order of the operations may be changed or operations may be merged. Hereinbelow, the description made with reference to FIGS. 1 to 7 will be omitted.

Referring to FIG. 8, the operating method of the battery diagnosis apparatus 100 may include operation S100 of measuring the shunt voltage of the current detection resistor (shunt resistor) included in the battery pack 1 in parallel connection to the current detection resistor and obtaining the shunt current based on the current detection resistor and the shunt voltage, operation S200 of determining whether the current detection resistor is diagnosable, operation S300 of storing the first voltage, which is a voltage of the battery pack 1 at the first point in time corresponding to the rest state of the battery pack 1, and the second voltage, which is a voltage of the battery pack 1 at the second point in time after the first interval from the first point in time, and operation S400 of diagnosing the state of the current detection resistor based on the difference between the second voltage and the first voltage and the shunt current.

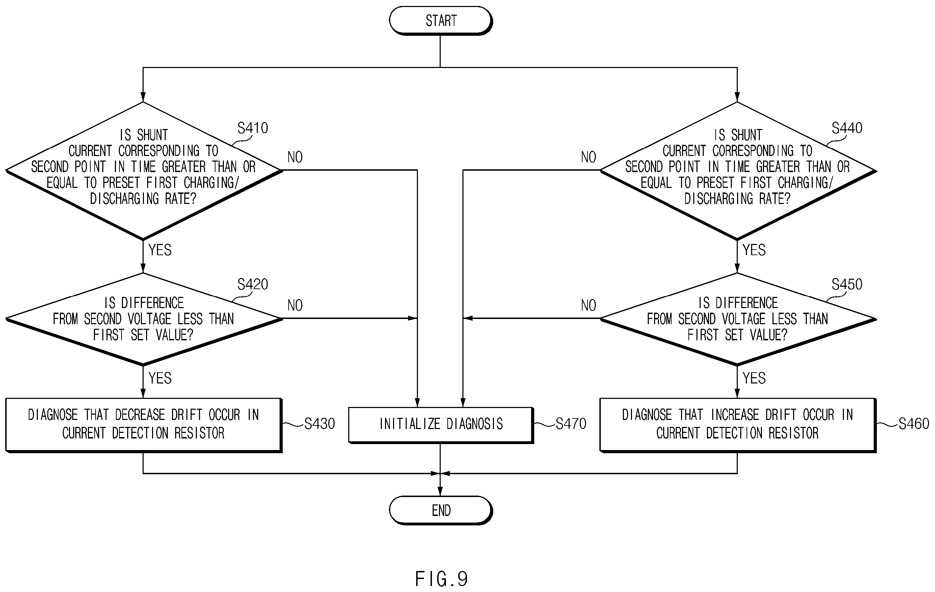

FIG. 9 is a flowchart showing in detail an operation of diagnosing a state of the current detection resistor of FIG. 8.

Referring to FIG. 9, the operation of diagnosing the state of the current detection resistor may include operation S410 of determining whether the shunt current corresponding to the second point tin time is greater than or equal to the first charging/discharging rate, operation S420 of determining whether the difference between the second voltage and the first voltage is less than the first set value, operation S430 of diagnosing that the decrease drift occurs in the current detection resistor, operation S440 of determining whether the shunt current corresponding to the second point in time is less than the preset second charging/discharging rate, operation S450 of determining whether the difference between the second voltage and the first voltage is greater than or equal to the second set value, operation S460 of diagnosing that the increase drift occurs in the current detection resistor, and operation S470 of initializing diagnosis.

When the battery diagnosis apparatus 100 determines that the shunt current corresponding to the second point in time is greater than or equal to the preset first charging/discharging rate in operation S410, the battery diagnosis apparatus 100 may perform operation S420. When the battery diagnosis apparatus 100 determines that the shunt current corresponding to the second point in time is less than the preset first charging/discharging rate, the battery diagnosis apparatus 100 may perform operation S470.

When the battery diagnosis apparatus 100 determines that the difference between the second voltage and the first voltage is less than the first set value in operation S420, the battery diagnosis apparatus 100 may perform operation S430. When the battery diagnosis apparatus 100 determines that the difference between the second voltage and the first voltage is greater than or equal to the first set value, the battery diagnosis apparatus 100 may perform operation S470.

When the battery diagnosis apparatus 100 determines that the shunt current corresponding to the second point in time is less than the second charging/discharging rate in operation S440, the battery diagnosis apparatus 100 may perform operation S450. When the battery diagnosis apparatus 100 determines that the shunt current corresponding to the second point in time is greater than or equal to the preset second charging/discharging rate, the battery diagnosis apparatus 100 may perform operation S470.

When the battery diagnosis apparatus 100 determines that the difference between the second voltage and the first voltage is greater than or equal to the second set value in operation S450, the battery diagnosis apparatus 100 may perform operation S460. When the battery diagnosis apparatus 100 determines that the difference between the second voltage and the first voltage is greater than or equal to the second set value, the battery diagnosis apparatus 100 may perform operation S470.

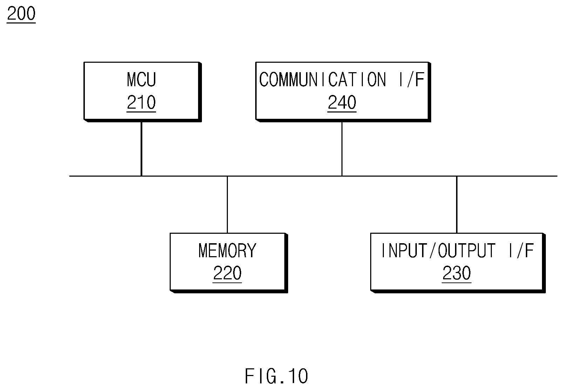

FIG. 10 is a block diagram showing a computing system that performs an operating method of a battery diagnosis apparatus according to an embodiment disclosed herein.

Referring to FIG. 10, a computing device 200 according to an embodiment disclosed herein may include a microcontroller unit (MCU) 210, a memory 220, an input/output interface (I/F) 230, and a communication I/F 240.

The MCU 210 may be a processor that executes various programs (e.g., an SOH calculation program, a cell balancing target determination program, etc.) stored in the memory 220, processes various data including an SOC, an SOH, etc., of the plurality of battery cells through these programs, and executes the above-described functions of the battery diagnosis apparatus 100 described with reference to FIGS. 1 to 9.

The memory 220 may store various programs regarding SOH calculation of the battery cell, cell balancing target determination, etc. Moreover, the memory 220 may store various data such as SOC data, SOH data, etc., of each battery cell.

The memory 220 may be provided in plural, depending on a need. The memory 220 may be a volatile or nonvolatile memory. For the memory 220 as the volatile memory, random access memory (RAM), dynamic RAM (DRAM), static RAM (SRAM), etc., may be used. For the memory 220 as the nonvolatile memory, read only memory (ROM), programmable ROM (PROM), electrically alterable ROM (EAROM), erasable PROM (EPROM), electrically erasable PROM (EEPROM), flash memory, etc., may be used. The above-listed examples of the memory 220 are merely examples and are not limited thereto.

The input/output I/F 230 may provide an interface for transmitting and receiving data by connecting an input device (not shown) such as a keyboard, a mouse, a touch panel, etc., and an output device such as a display (not shown), etc., with the MCU 210.

The communication I/F 240, which is a component capable of transmitting and receiving various data to and from a server, may be various devices capable of supporting wired or wireless communication. For example, a program for SOH calculation of the battery cell or balancing target determination or various data, etc., may be transmitted and received to and from a separately provided external server through the communication I/F 240.

As such, the operating method of the battery diagnosis apparatus according to an embodiment disclosed herein may be recorded in the memory 220 and executed by the MCU 210.

The above description is merely illustrative of the technical idea of the present disclosure, and various modifications and variations will be possible without departing from the essential characteristics of embodiments of the present disclosure by those of ordinary skill in the art to which the embodiments disclosed herein pertains.

Therefore, the embodiments disclosed herein are intended for description rather than limitation of the technical spirit of the embodiments disclosed herein and the scope of the technical spirit of the present disclosure is not limited by these embodiments disclosed herein. The protection scope of the technical spirit disclosed herein should be interpreted by the following claims, and all technical spirits within the same range should be understood to be included in the range of this document.

### [EXPLANATION OF REFERENCE NUMERALS DESIGNATING THE MAJOR ELEMENTS OF THE DRAWINGS]

100: BATTERY DIAGNOSIS APPARATUS
110: INFORMATION OBTAINING UNIT
120: STORAGE UNIT
130: CONTROL UNIT

## Claims

1. A battery diagnosis apparatus comprising:
an information obtaining unit configured to obtain a shunt voltage and a shunt current of a current detection resistor (shunt resistor) included a battery pack;
a storage unit configured to store a voltage of the battery pack; and
a control unit configured to:
store a first voltage, which is a voltage of the battery pack at a first point in time corresponding to a rest state of the battery pack, and a second voltage, which is a voltage of the battery pack at a second point in time after a first interval from the first point in time; and
diagnose a state of the current detection resistor, based on the difference between the second voltage and the first voltage and the shunt current.

2. The battery diagnosis apparatus of claim 1, wherein the control unit is further configured to diagnose that a decrease drift occurs in the current detection resistor when the shunt current corresponding to the second point in time is greater than or equal to a preset first charging/discharging rate and the difference between the second voltage and the first voltage is less than a first set value.

3. The battery diagnosis apparatus of claim 2, wherein the control unit is further configured to:
store a third voltage, which is a voltage of the battery pack at a third point in time after a second interval from the first point in time; and
verify a diagnosis result based on a difference between the third voltage and the first voltage.

4. The battery diagnosis apparatus of claim 2, wherein the control unit is further configured to determine the first set value based on a temperature of the battery pack.

5. The battery diagnosis apparatus of claim 4, wherein the first set value is proportional to the temperature of the battery pack.

6. The battery diagnosis apparatus of claim 1, wherein the control unit is further configured to diagnose that an increase drift occurs in the current detection resistor when the shunt current corresponding to the second point in time is less than a preset second charging/discharging rate and the difference between the second voltage and the first voltage is greater than or equal to the second set value.

7. The battery diagnosis apparatus of claim 6, wherein the control unit is further configured to:
store a third voltage, which is a voltage of the battery pack at a third point in time after a second interval from the first point in time; and
verify a diagnosis result based on the difference between the third voltage and the first voltage.

8. The battery diagnosis apparatus of claim 1, wherein the control unit is further configured to diagnose the state of the current detection resistor when a rest time, which is a retention time of the rest state of the battery pack before the first point in time, is greater than or equal to a preset time.

9. The battery diagnosis apparatus of claim 8, wherein the control unit is further configured to initialize a state diagnosis of the current detection resistor when the rest time is less than the preset time.

10. An operating method of a battery diagnosis apparatus, the operating method comprising:
measuring a shunt voltage of a current detection resistor (shunt resistor) included in a battery pack in parallel connection with the current detection resistor and obtaining a shunt current based on the current detection resistor and the shunt voltage;
determining whether the current detection resistor is diagnosable;
storing a first voltage, which is a voltage of the battery pack at a first point in time corresponding to a rest state of the battery pack, and a second voltage, which is a voltage of the battery pack at a second point in time after a first interval from the first point in time; and
diagnosing a state of the current detection resistor, based on the difference between the second voltage and the first voltage and the shunt current.

11. The operating method of claim 10, wherein the diagnosing comprises diagnosing that a decrease drift occurs in the current detection resistor when the shunt current corresponding to the second point in time is greater than or equal to a preset first charging/discharging rate and the difference between the second voltage and the first voltage is less than a first set value.

12. The operating method of claim 11, wherein the diagnosing comprises verifying a diagnosis result based on a difference between the first voltage and a third voltage, which is a voltage of the battery pack at a third point in time after a second interval from the first point in time.

13. The operating method of claim 11, wherein the first set value is determined based on the temperature of the battery pack.

14. The operating method of claim 10, wherein the diagnosing comprises diagnosing that an increase drift occurs in the current detection resistor when the shunt current corresponding to the second point in time is less than a preset second charging/discharging rate and the difference between the second voltage and the first voltage is greater than or equal to a second set value.

15. The operating method of claim 10, wherein the determining of whether the current detection resistor is diagnosable comprises:
diagnosing the state of the current detection resistor when a rest time, which is a retention time of the rest state of the battery pack before the first point in time, is greater than or equal to a preset time; and
initializing diagnosis of the state of the current detection resistor when the rest time is less than the preset time.
